(19) Europäisches Patentamt
European Patent Office
Office européen des brevets

(11) **EP 4 788 100 A1**

(12) **EUROPEAN PATENT APPLICATION**
published in accordance with Art. 153(4) EPC

(43) Date of publication:
**05.08.2026 Bulletin 2026/32**

(21) Application number: **25842577.6**

(22) Date of filing: **04.07.2025**

(51) International Patent Classification (IPC):
*H10K 30/50* (2023.01)

(86) International application number:
**PCT/CN2025/106976**

(87) International publication number:
**WO 2026/103185 (21.05.2026 Gazette 2026/21)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **18.11.2024 CN 202411640576**

(71) Applicant: **Trina Solar Co., Ltd**
**Changzhou, Jiangsu 213031 (CN)**

(72) Inventors:
• **ZHU, Changhuai**
  **Changzhou, Jiangsu 213031 (CN)**
• **LI, Hongjiang**
  **Changzhou, Jiangsu 213031 (CN)**
• **ZHANG, Xueling**
  **Changzhou, Jiangsu 213031 (CN)**

(74) Representative: **Nederlandsch Octrooibureau**
**P.O. Box 29720**
**2502 LS The Hague (NL)**

(54) **TANDEM SOLAR CELL AND PREPARATION METHOD**

(57) The present invention provides a tandem solar cell and a method for preparing the same. The tandem solar cell comprises a front electrode, a first stacked layer, a tunneling recombination layer, a second stacked layer, and a back electrode, and a first deposited metal layer is provided between the front electrode and the first stacked layer. The first deposited metal layer is configured to improve the adhesion between the metal paste and the cell, reduce the contact resistance therebetween, and thereby enhance the electrical conductivity between the metal electrode and the perovskite during the low-temperature preparation of the tandem cell electrodes.

FIG.1

**Description**

**Technical Field**

The present invention relates to a technical field of new energy, and in particular, to a tandem solar cell and a method for preparing the same.

**Background**

Organic-inorganic metal halide perovskite materials are suitable for use as absorber layers in solar cells by virtue of their excellent optoelectronic properties and low-cost advantages. Meanwhile, perovskite materials have a tunable bandgap, enabling them to be stacked with other photovoltaic materials having different bandgaps to form tandem solar cells, thereby achieving extremely high power conversion efficiency. Tandem solar cells combining perovskite and crystalline silicon can effectively improve the conversion efficiency of solar cells.

In the prior art, directly applying a method for preparing crystalline silicon electrodes under high-temperature conditions to the preparation of tandem cells leads to a decrease in the reproducibility and stability of the cells. Therefore, low-temperature sintering is typically employed in the preparation of perovskite/crystalline silicon tandem solar cells. However, the printing paste itself contains certain polymers. Directly printing the metal paste results in poor adhesion between the paste and the cell, leading to a significant loss in the fill factor of the cell and seriously affecting the contact resistance and conductivity.

To overcome the aforementioned drawbacks of the prior art, there is an urgent need in the art for a tandem solar cell technology that, during the low-temperature preparation of tandem cell electrodes, improves the adhesion between the metal paste and the cell, reduces the contact resistance therebetween, and thereby enhances the electrical conductivity between the metal electrode and the perovskite.

**Summary**

A brief overview of one or more aspects is provided below to provide a basic understanding of these aspects. The summary is not an extensive overview of all of the aspects that are contemplated, and is not intended to identify key or decisive elements in all aspects nor attempt to define the scope of any or all aspects. The sole purpose of the summary is to present some concepts of one or more aspects in a simplified form as a prelude to the more detailed description that is presented later.

To overcome the aforementioned drawbacks of the prior art, the present invention provides a tandem solar cell and a method for preparing the same. The present invention is configured to improve the adhesion between the metal paste and the cell, reduce the contact resistance therebetween, and thereby enhance the electrical conductivity between the metal electrode and the perovskite during the low-temperature preparation of tandem cell electrodes.

Specifically, the tandem solar cell provided according to a first aspect of the present invention comprises: a front electrode, a first stacked layer, a tunneling recombination layer, a second stacked layer, and a back electrode, and a first deposited metal layer is provided between the front electrode and the first stacked layer.

Further, in some embodiments of the present invention, the first deposited metal layer comprises a metal material, and the metal material comprises: any one selected from silver, gold, copper, aluminum, iron, chromium and molybdenum, or an alloy of two or more metals selected from silver, gold, copper, aluminum, iron, chromium and molybdenum.

Further, in some embodiments of the present invention, the first deposited metal layer comprises a metal material in a mass ratio of 85% to 95%.

Further, in some embodiments of the present invention, the first deposited metal layer has a thickness ranging from 5nm to 2000nm.

Further, in some embodiments of the present invention, the first deposited metal layer comprises silver, and a thickness of the first deposited metal layer ranges from 20nm to 2000nm; or the first deposited metal layer comprises a metal material selected from gold, copper, aluminum, iron, chromium, molybdenum, or silver-copper alloy, and a thickness of the first deposited metal layer ranges from 20nm to 200nm, respectively.

Further, in some embodiments of the present invention, the first deposited metal layer is a multi-layer structure, and the multi-layer structure is formed by depositing a plurality of layers of the metal materials.

Further, in some embodiments of the present invention, the first deposited metal layer comprises a gold-silver bilayer structure or an aluminum-iron bilayer structure.

Further, in some embodiments of the present invention, the gold-silver bilayer structure or the aluminum-iron bilayer structure has a thickness ranging from 20nm to 200nm.

Further, in some embodiments of the present invention, a gold deposited metal layer and a silver deposited metal layer of the gold-silver bilayer structure have a same thickness, or an aluminum deposited metal layer and an iron deposited metal layer of the aluminum-iron bilayer structure have a same thickness.

Further, in some embodiments of the present invention, a deposition process of the first deposited metal layer comprises at least one selected from thermal evaporation deposition, ion beam deposition, reactive plasma deposition, electron beam deposition and sputtering deposition, and the first deposited metal layer is deposited between the front electrode and the first stacked layer via the deposition process.

Further, in some embodiments of the present invention, the first deposited metal layer is formed via electron beam deposition, and: the first deposited metal layer is made of silver with a thickness ranging from 20nm to 2000nm; the first deposited metal layer has a gold-silver bilayer structure with a thickness ranging from 20nm to 200nm; or the first deposited metal layer is made of a silver-copper alloy with a thickness ranging from 20nm to 200nm.

Further, in some embodiments of the present invention, the first deposited metal layer has a pattern consistent with that of metal grid lines between the first deposited metal layer and the first stacked layer.

Further, in some embodiments of the present invention, the tandem solar cell further comprises a second deposited metal layer, provided between the back electrode and the second stacked layer.

Further, in some embodiments of the present invention, the first stacked layer comprises a hole transport layer, a first absorber layer, an electron transport layer and a first transparent conductive layer, the tunneling recombination layer is a transparent conductive oxide layer, and the second stacked layer comprises a second transparent conductive layer and a second absorber layer.

Additionally, according to the method for preparing a tandem solar cell provided in a second aspect of the present invention, it comprises the following steps: preparing a second stacked layer of the tandem solar cell, wherein the second stacked layer comprises a first surface and a second surface opposite to each other, the second surface is a light-receiving surface; forming a tunneling recombination layer on the second surface of the second stacked layer; forming a first stacked layer on a surface of the tunneling recombination layer remote from the second stacked layer; forming a first deposited metal layer on a surface of the first stacked layer remote from the tunneling recombination layer; and forming a front electrode on a surface of the first deposited metal layer remote from the first stacked layer, and forming a back electrode on a surface of the second stacked layer remote from the tunneling recombination layer.

### Brief Description of the Drawings

The above features and advantages of the present invention will be better understood after reading the detailed description of the embodiments of the present disclosure in conjunction with the following figures. In the figures, components are not necessarily drawn to scale, and components having similar related features may have the same or similar reference numerals.

Fig. 1 is a schematic structural diagram of a tandem solar cell according to some embodiments of the present invention.

Fig. 2 is a schematic flow diagram of a method for preparing a tandem solar cell according to some embodiments of the present invention.

Fig. 3 is a schematic material diagram of a tandem solar cell according to some embodiments of the present invention.

Reference numerals

110      back electrode;
111      second stacked layer;
1111     second transparent conductive layer;
1112     second absorber layer;
112      tunneling recombination layer;
113      first stacked layer;
1131     hole transport layer;
1132     first absorber layer;
1133     electron transport layer;
1134     first transparent conductive layer;
114      front electrode;
120      first deposited metal layer;
121      second deposited metal layer.

**Detailed Description of Embodiments**

The embodiments of the present invention are described in the following detailed description. Other advantages and effects of the present invention will be readily apparent to those skilled in the art from this disclosure. Although the description of the present invention will be described in conjunction with the preferred embodiments, this does not mean that the features of the present invention are limited to these embodiments. On the contrary, the invention is described in connection with the embodiments so as to cover other alternatives or modifications that may be extended based on the claims of the present invention. In order to provide a thorough understanding of the present invention, many specific details are included in the following description. The present invention may also be practiced without these details. In addition, some specific details are omitted in the description in order to avoid confusing or obscuring the key points of the present invention.

In the description of the present invention, it should be noted that the terms "installation", "connecting", and "connected" should be understood broadly unless explicitly stated and defined otherwise. For example, the terms "installation", "connecting", and "connected" may be either a fixed connection, a detachable connection, or an integral connection; the terms may be either a mechanical connection or an electrical connection; the terms also may be either a direct connection, an indirect connection through an intermediate medium, or an internal connection between two components. The specific meaning of the above terms in the present invention can be understood in a specific case by those skilled in the art.

In addition, "up", "down", "left", "right", "top", "bottom", "horizontal", "vertical" used in the following description shall be understood as the orientation described in the paragraph and shown in the related figure. The relative terms are used for convenience of description only, and does not mean that the device described therein is to be manufactured or operated in the specific orientation, and therefore should not be construed as limiting the present invention.

Understandably, although the terms "first", "second", "third", etc. may be used to describe various components, regions, layers and/or portions to distinguish different components, regions, layers and/or portions, these components, regions, layers and/or portions described above should not be limited by the terms, and these terms are only used to distinguish different components. Therefore, a first component, region, layer and/or portion mentioned below may be also be referred to as a second component, region, layer and/or portion without departing from some embodiments of the present invention.

As described above, in the prior art, directly applying the method for preparing crystalline silicon electrodes under high-temperature conditions to the preparation of tandem cells leads to a decrease in the reproducibility and stability of the cells. Therefore, low-temperature sintering is typically employed in the preparation of perovskite/crystalline silicon tandem solar cells. However, this low-temperature sintering preparation means results in poor conductivity of the metal electrodes, thereby consuming a large amount of materials (e.g., silver paste) used for electrode preparation.

To overcome the aforementioned drawbacks of the prior art, the present invention provides a tandem solar cell configured to improve the adhesion between the metal paste and the cell during the low-temperature preparation of tandem cell electrodes, thereby enhancing the electrical conductivity of the metal electrode to reduce the usage amount of the metal paste.

In some non-limiting embodiments, the method for preparing a tandem solar cell provided in the second aspect of the present invention may be implemented based on the tandem solar cell provided according to the first aspect of the present invention.

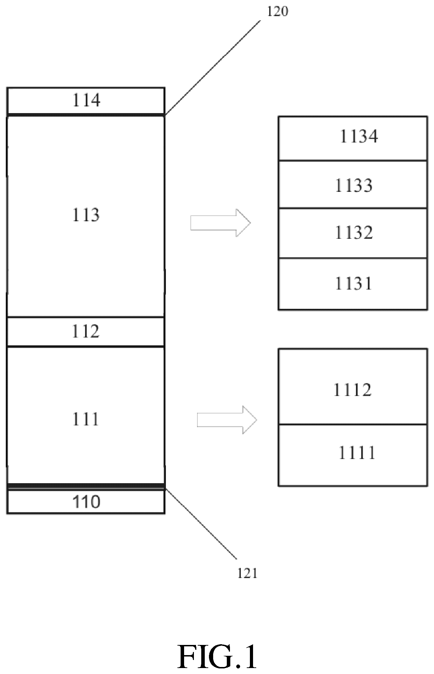

Please refer to Fig. 1 for details. Fig. 1 is a schematic structural diagram of a tandem solar cell according to some embodiments of the present invention.

As shown in Fig. 1, a tandem solar cell comprises a front electrode 114, a first stacked layer 113, a tunnel recombination layer 112, a second stacked layer 111, and a back electrode 110, wherein a first deposited metal layer 120 is provided between the front electrode 114 and the first stacked layer 113.

In some embodiments, the tandem solar cell further comprises a second deposited metal layer 121, provided between the back electrode 110 and the second stacked layer 111.

In some embodiments, the first deposited metal layer 120 comprises a metal material. The metal material comprises any one selected from silver, gold, copper, aluminum, iron, chromium and molybdenum, or an alloy of two or more metals selected from silver, gold, copper, aluminum, iron, chromium and molybdenum. Herein, the first deposited metal layer should be understood as a single-layer structure. A metal layer material included in the single-layer structure may be selected from one of the aforementioned silver, gold, copper, aluminum, iron, chromium, and molybdenum, or an alloy of two or more thereof.

In some embodiments, the first deposited metal layer 120 comprises a metal material in a mass ratio of 85% to 95%. In addition, it may further comprise epoxy resin and organic additives in a mass ratio of 5% to 15%.

In some embodiments, the first deposited metal layer 120 has a thickness ranging from 5nm to 2000nm.

In some embodiments, the metal material of the first deposited metal layer 120 may comprise silver. Herein, the thickness of the silver-containing first deposited metal layer may range from 20nm to 2000nm. Herein, since a thickness of less than 20nm may result in an occurrence of an incomplete metal layer, i.e., a discontinuous coating, selecting a thickness greater than 20nm not only ensures the stability of the coating, but also achieves an optimal metal resistivity, thereby improving the overall performance of the solar cell.

Alternatively, a thickness of the silver may range from 20nm to 100nm. Herein, since the change in resistivity is generally small when the thickness exceeds 100nm, selecting this thickness range not only ensures the stability of the coating, but also saves the amount of metal paste used, thereby reducing manufacturing costs.

In some embodiments, the metal material of the first deposited metal layer 120 further comprises a metal material selected from gold, copper, aluminum, iron, chromium, molybdenum, or silver-copper alloy. Herein, a thickness of the first deposited metal layer ranges from 20nm to 200nm, respectively.

Herein, since a thickness of less than 20nm may result in an occurrence of an incomplete metal layer, i.e., a discontinuous coating, selecting a thickness greater than 20nm not only ensures the stability of the coating, but also achieves an optimal contact resistivity of the metal electrode, thereby improving the overall performance of the solar cell. Since the change in the contact resistivity of the metal electrode is generally small when the thickness exceeds 200nm, selecting this thickness range not only ensures the stability of the coating, but also saves the amount of metal paste used, thereby reducing manufacturing costs.

Herein, since conventional gold, silver, and copper all have relatively good electrical conductivity, the variation value of the contact resistivity of the metal electrode is relatively small as the thickness increases beyond 20nm. In contrast, since aluminum, iron, chromium, and molybdenum have relatively poor electrical conductivity, compared with gold, silver, and copper, when the thickness is increased by the same amount, the variation value of the metal resistivity is relatively larger, resulting in a greater improvement in electrical conductivity.

In some embodiments, the second stacked layer 111 of the tandem solar cell comprises a second transparent conductive layer 1111 and a second absorber layer 1112. Herein, the second transparent conductive layer 1111 is generally a transparent conductive oxide film (e.g., ITO, IZO, IWO), which can be used to allow light to penetrate and serve as the anode at the same time. The second absorber layer 1112 may comprise at least one of crystalline silicon, perovskite, CdTe, CIGS, and GaAs materials. Herein, the second absorber layer 1112 may also adopt a heterojunction with intrinsic thin-layer (HJT) cell, thereby reducing the preparation process and improving the preparation efficiency.

In some embodiments, the tunneling recombination layer 112 of the tandem solar cell may adopt at least one of ITO, IWO, and Ag, so as to facilitate electrons to pass through the material layers more rapidly, reduce the recombination loss of electrons inside the materials, and thereby improve the electron transport efficiency and overall performance of the cell.

In some embodiments, the first stacked layer 113 of the tandem solar cell comprises a hole transport layer 1131, a first absorber layer 1132, an electron transport layer 1133 and a first transparent conductive layer 1134.

In some embodiments, in the first stacked layer 113 of the tandem solar cell, the hole transport layer 1131 may comprise a self-assembled monolayer and an anchoring layer. Specifically, the anchoring layer comprises at least one of ITO, IZO, IWO, FTO, ICO, AZO, BZO, nanocrystalline silicon, $TiO_2$, $SnO_2$, $NiO_x$ and $AlO_x$. The self-assembled monolayer in the hole transport layer 1131 comprises at least one of [2-(9H-carbazol-9-yl) ethyl]phosphonic acid (2PACz), [2-(3,6-dimethoxy-9H-carbazol-9-yl) ethyl]phosphonic acid (MeO-2PACz), [4-(3,6-dimethyl-9H-carbazol-9-yl)butyl]phosphonic acid (Me-4PACz), benzoic acid, and 4-[bis(2,4-dimethoxybiphenyl-4-yl)amino]-biphenyl-4-carboxylic acid (MC-43).

Those skilled in the art will appreciate that the structure of the aforementioned hole transport layer 1131 is merely a non-limiting embodiment provided by the present invention, which is intended to clearly illustrate the core concept of the present invention and provide a specific solution that facilitates implementation by the public, rather than to limit the scope of protection of the present invention.

Alternatively, in other embodiments, in the first stacked layer 113 of the tandem solar cell, the hole transport layer 1131 may further comprise a plurality of p-type layers for transporting holes, wherein the materials of the p-type layers comprise at least one of p-type monocrystalline silicon, p-type polycrystalline silicon, p-type amorphous silicon and monomolecular self-assembled materials, and the thickness thereof is not greater than $100\mu m$.

In some embodiments, the first absorber layer 1132 may be made of a perovskite material for absorbing photons and generating electron-hole pairs. The perovskite material has a three-dimensional structure of $ABX_3$, wherein A is a monovalent cation, B is a divalent cation and X is a monovalent anion. Specifically, the monovalent cation A comprises but is not limited to one or more types of monovalent cations or a mixture thereof selected from cesium (Cs), rubidium (Rb), methylammonium ($CH_3NH_3^+$) and formamidinium($(CH_2NH_2)_2^+$). The divalent cation B comprises but is not limited to one or more types of divalent cations or a mixture thereof selected from lead (Pb), copper (Cu), zinc (Zn), gallium (Ga), tin (Sn) and calcium (Ca). The monovalent anion X comprises but is not limited to one or more types of monovalent anions or a mixture thereof selected from iodine ($I^-$), bromine ($Br^-$), chlorine ($Cl^-$), fluorine ($F^-$) and thiocyanate ion ($SCN^-$). Herein, the perovskite material may be coated on the self-assembled monolayer via at least one of the doctor blade coating method, slot-die coating method, screen printing method and inkjet printing method, and its thickness may range from 10nm to $100\mu m$ while its band gap may range from 0.9eV to 3.0eV. Prior to preparation, the perovskite precursor is usually mixed with a plurality of solvents so as to obtain a perovskite precursor solution, wherein the molar ratio of each solvent to the precursor complex ranges from 0.001 to 1.

In some embodiments, the electron transport layer 1133 may further comprise a plurality of n-type layers for transporting electrons, wherein the materials of the n-type layers comprise at least one of n-type monocrystalline silicon, n-type polycrystalline silicon, n-type amorphous silicon, $TiO_2$, $SnO_2$, ZnO, $ZrO_2$, GZO, IZO, FTO, ITO, $BaSnO_3$, $TiSnO_x$, $SnZnO_x$, fullerenes and derivatives thereof, and the thickness thereof is not greater than $100\mu m$.

In some embodiments, the first transparent conductive layer 1134 is generally a transparent conductive oxide film (e.g., ITO, IZO, IWO), which can be used to allow light to penetrate and to serve as the cathode.

In some embodiments, the material of the metal paste of the front electrode 114 and/or the back electrode 110 comprises at least one of Au, Ag, Al, Cu, graphene, TCO and nanocrystalline silicon, and the thickness thereof may be not greater than $10\mu m$.

In some embodiments, the first deposited metal layer 120 may be deposited prior to the printing of the metal paste, so as to improve the adhesion between the metal paste and the cell during the low-temperature preparation of the tandem cell electrode, thereby enhancing the electrical conductivity of the metal electrode and further reducing the consumption of the metal paste.

In some embodiments, a deposition process of the first deposited metal layer 120 comprises at least one selected from thermal evaporation deposition, ion beam deposition, reactive plasma deposition, electron beam deposition and sputtering deposition. The first deposited metal layer 120 is deposited between the front electrode 114 and the first stacked layer 113 via the aforesaid deposition process. The first deposited metal layer 120 may have a pattern consistent with that of the metal grid lines between the first deposited metal layer 120 and the first stacked layer 113.

Further, for the thermal evaporation deposition process, the vacuum pressure is $4 \times 10^{-4}$ torr, the voltage is 3V, the current is 160A, and the evaporation rate is 0.4Å/s. For the reactive plasma deposition process, the vacuum pressure is $3 \times 10^{-5}$ torr, the current is 130A, the argon flow rate of the electron gun is 40sccm, the chamber shielding gas is argon, and the evaporation rate is 0.4Å/s. For the electron beam deposition process, the vacuum pressure is $4 \times 10^{-4}$ torr, the voltage is 20kV, the singlegun power ranges from 70W to 100W, and the evaporation rate is 0.5Å/s.

Further, in some embodiments, the first deposited metal layer 120 may be formed via electron beam deposition. And the first deposited metal layer 120 may be made of silver with a thickness ranging from 20 nm to 2000 nm. The first deposited metal layer 120 may have a gold-silver bilayer structure with a thickness ranging from 20 nm to 200 nm. The first deposited metal layer 120 may be made of a silver-copper alloy with a thickness ranging from 20 nm to 200 nm.

In some embodiments, the first deposited metal layer 120 is a multi-layer structure, and the multi-layer structure is formed by depositing a plurality of layers of the metal materials. The materials of the metal layers comprised in the multi-layer structure may be selected from one type of silver, gold, copper, aluminum, iron, chromium and molybdenum, or an alloy of two or more types of the aforesaid metals. Preferably, the first deposited metal layer 120 may comprise a gold-silver bilayer structure or an aluminum-iron bilayer structure. The gold-silver bilayer structure or the aluminum-iron bilayer structure has a thickness ranging from 20nm to 200nm. In the gold-silver bilayer structure, a thickness of a gold deposited metal layer is equal to that of a silver deposited metal layer. Alternatively, in the aluminum-iron bilayer structure, a thickness of an aluminum deposited metal layer is equal to that of an iron deposited metal layer.

Herein, the metal layers of the multi-layer structure can reduce the resistance of the first deposited metal layer 120. Specifically, the metal layers of the multi-layer structure can reduce the contact resistance with the metal electrode while depositing more stable metals, so as to achieve the purpose of enhancing stability.

The working principle of the aforesaid tandem solar cell will be described below in conjunction with some embodiments of the preparation methods of the tandem solar cell. Those skilled in the art will appreciate that these embodiments of the preparation methods for the tandem solar cell are merely non-limiting implementations provided by the present invention, which are intended to clearly demonstrate the core concept of the present invention and provide specific schemes conducive to public implementation, rather than to limit all the preparation methods of the tandem solar cell.

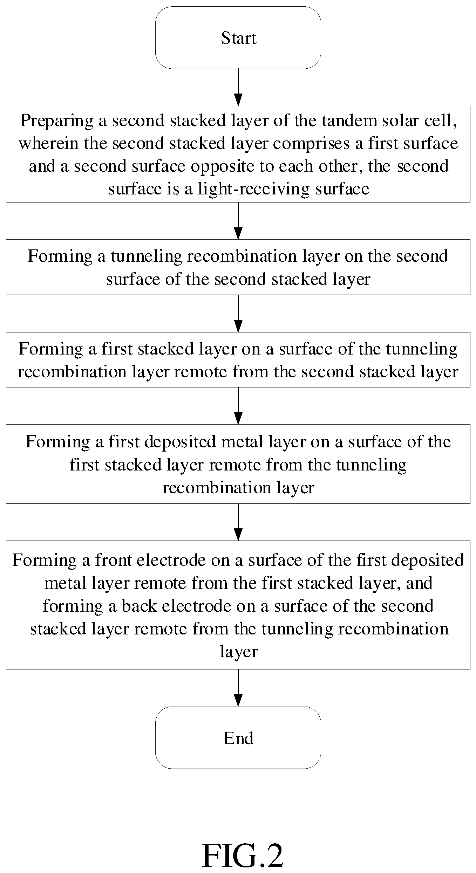

Please refer to Figures 2 to 3. Fig. 2 is a schematic flow diagram of a method for preparing a tandem solar cell according to some embodiments of the present invention.

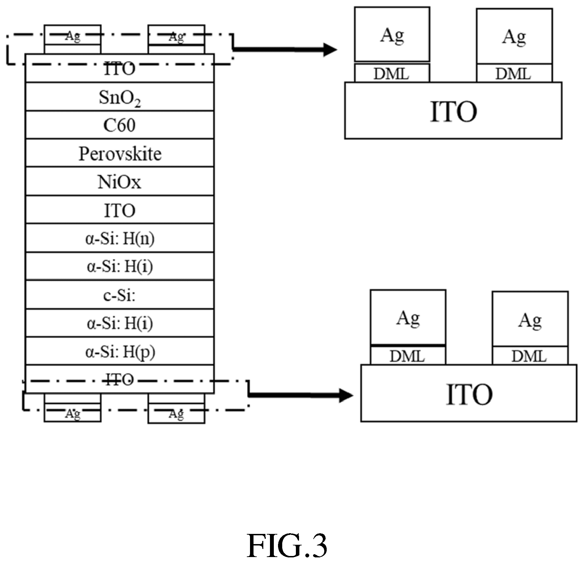

Fig. 3 is a schematic material diagram of a tandem solar cell according to some embodiments of the present invention.

As shown in Figures 2 to 3, a method of preparing the tandem solar cell may first perform Step S1: preparing a second stacked layer 111 of the tandem solar cell, wherein the second stacked layer 111 comprises a first surface and a second surface opposite to each other, and the second surface is a light-receiving surface.

Specifically, a preparation method of the second absorber layer 1112 comprises the following steps: first, selecting an N-type silicon wafer. Then, successively forming an intrinsic amorphous silicon layer and an N-type amorphous silicon layer on a second surface of the N-type silicon wafer, wherein the N-type amorphous silicon layer serves as a second surface of the second absorber layer 1112. Subsequently, successively forming an intrinsic amorphous silicon layer and a P-type amorphous silicon layer on a first surface of the N-type silicon wafer, wherein the P-type amorphous silicon layer serves as a first surface of the second absorber layer 1112. For example, a maximum height h of the surface line marks on the N-type silicon wafer may be $5\mu m$, and a maximum inclination angle $\theta$ of the surface line marks on the N-type silicon substrate may be 30°. Then, a plasma enhanced chemical vapor deposition (PECVD) method is adopted to successively deposit an intrinsic amorphous silicon layer with a thickness of 5nm and an N-type amorphous silicon layer with a thickness of 20nm on the second surface of the N-type silicon wafer, respectively. Subsequently, the PECVD method is adopted to successively deposit a 5-nm-thick intrinsic amorphous silicon layer and a 20-nm-thick P-type amorphous silicon layer on the first surface of the N-type silicon wafer, respectively. Thereafter, a second transparent conductive layer 1111 is formed on the first surface of the second absorber layer 1112. For example, a sputtering deposition method is adopted to deposit an indium tin oxide (ITO) transparent conductive oxide layer on a surface of the P-type amorphous silicon layer remote from the N-type silicon wafer, with a thickness of 130 nm.

Then, the preparation method of the tandem solar cell may perform Step S2: forming a tunnel recombination layer 112 on the second surface of the second stacked layer 111.

Specifically, the tunneling recombination layer 112 can be fabricated on the second surface of the second absorber layer 1112 by means of the sputtering deposition method, which involves depositing a 50-nm-thick indium tin oxide (ITO) transparent conductive oxide layer on a surface of the N-type amorphous silicon layer that is remote from the N-type silicon wafer.

Subsequently, the preparation method of the tandem solar cell may perform Step S3: forming a first stacked layer 113 on a surface of the tunneling recombination layer 112 remote from the second stacked layer 111.

Specifically, a 30-nm-thick NiO layer is deposited on a surface of the ITO-based tunneling recombination layer 112 (a transparent conductive oxide layer) on the second surface by means of magnetron sputtering. Then, a perovskite absorber layer of $Cs_{0.25}FA_{0.75}Pb(I_{0.8}Br_{0.2})_3$ is formed on a surface of the NiO layer via solution spincoating, with a band gap of approximately 1.68eV and a thickness of 500 nm. Subsequently, a 15-nm-thick $C_{60}$ layer is deposited on a surface of the perovskite absorber layer by means of thermal evaporation, and a 15-nm-thick $SnO_2$ layer is fabricated on a surface of the $C_{60}$ layer via atomic layer deposition. Thereafter, a 100-nm-thick ITO layer is prepared on a surface of the $SnO_2$ layer by sputtering.

Optionally, a 2-nm-thick LiF layer may be deposited on the surface of the perovskite absorber layer prior to the deposition of the $C_{60}$ layer, so as to prevent oxidation or corrosion on the electrode surface, reduce energy loss during the internal energy conversion process of the solar cell, and thereby enhance the stability and service life of the solar cell.

Then, the preparation method of the tandem solar cell may perform Step S4: forming a first deposited metal layer 120 on a surface of the first stacked layer 113 remote from the tunneling recombination layer 112.

Finally, the preparation method of the tandem solar cell may perform Step S5: forming a front electrode 114 on a surface of the first deposited metal layer 120 remote from the first stacked layer 113, and forming a back electrode 110 on a surface of the second stacked layer 111 remote from the tunneling recombination layer 112.

Optionally, a second deposited metal layer 121 may be fabricated prior to forming a back electrode 110 on a surface of the second stacked layer 111 remote from the tunneling recombination layer 112. Herein, all physicochemical properties of the second deposited metal layer are the same as those of the first deposited metal layer, which will not be repeated herein.

Please refer to Table 1. Table 1 presents the examples and comparative example of the performance parameters of the tandem solar cell under the structure provided with the first deposited metal layer 120.

Table 1

| Deposited Metal Layer Type | Fabrication Process | Deposited Metal Layer Material | Deposited Metal Layer Thickness (nm) | Contact Resistivity of the Metal Electrode ($\Omega\cdot cm$) | Open Circuit Voltage (V) | Current Density ($mA/cm^2$) | Fill Factor (%) | Conversion Efficiency (%) |
|---|---|---|---|---|---|---|---|---|
| Single Layer | Thermal Evaporation | Silver (Ag) | 5 | 13 | 1.92 | 19.56 | 78.67 | 29.08 |
| Single Layer | Thermal Evaporation | Silver (Ag) | 20 | 8 | 1.94 | 19.65 | 79.25 | 30.21 |
| Single Layer | Thermal Evaporation | Silver (Ag) | 50 | 8 | 1.94 | 19.47 | 79.87 | 30.17 |
| Single Layer | Thermal Evaporation | Silver (Ag) | 100 | 7 | 1.93 | 19.56 | 79.46 | 29.99 |
| Single Layer | Thermal Evaporation | Silver (Ag) | 2000 | 5 | 1.94 | 19.58 | 80.34 | 30.32 |

(continued)

| Deposited Metal Layer Type | Fabrication Process | Deposited Metal Layer Material | Deposited Metal Layer Thickness (nm) | Contact Resistivity of the Metal Electrode ($\Omega \cdot cm$) | Open Circuit Voltage (V) | Current Density (mA/cm$^2$) | Fill Factor (%) | Conversion Efficiency (%) |
|---|---|---|---|---|---|---|---|---|
| Single Layer | Reactive Plasma Deposition | Silver (Ag) | 100 | 6 | 1.93 | 19.67 | 79.76 | 30.28 |
| Single Layer | Electron Beam Deposition | Silver (Ag) | 50 | 7 | 1.95 | 19.57 | 80.23 | 30.77 |
| Single Layer | Electron Beam Deposition | Silver (Ag) | 100 | 4 | 1.94 | 19.87 | 79.65 | 30.7 |
| Single Layer | Thermal Evaporation | Gold (Au) | 20 | 4 | 1.94 | 19.76 | 81.98 | 31.43 |
| Single Layer | Thermal Evaporation | Gold (Au) | 200 | 3 | 1.95 | 19.56 | 81.79 | 31.20 |
| Single Layer | Thermal Evaporation | Gold (Au) | 5 | 10 | 1.94 | 19.69 | 79.87 | 30.51 |
| Single Layer | Thermal Evaporation | Copper (Cu) | 20 | 7 | 1.94 | 19.34 | 80.12 | 30.06 |
| Single Layer | Thermal Evaporation | Copper (Cu) | 200 | 5 | 1.93 | 19.63 | 80.43 | 30.47 |
| Single Layer | Thermal Evaporatio n | Copper (Cu) | 5 | 20 | 1.94 | 19.56 | 78.65 | 29.84 |
| Single Layer | Thermal Evaporatio n | Aluminum (Al) | 20 | 13 | 1.94 | 19.24 | 78.87 | 29.44 |
| Single Layer | Thermal Evaporatio n | Aluminum (Al) | 200 | 8 | 1.93 | 19.65 | 80.76 | 30.63 |
| Single Layer | Thermal Evaporation | Aluminum (Al) | 5 | 27 | 1.93 | 19.65 | 77.99 | 29.58 |
| Single Layer | Thermal Evaporation | Iron (Fe) | 20 | 16 | 1.94 | 19.66 | 78.69 | 30.01 |
| Single Layer | Thermal Evaporation | Iron (Fe) | 200 | 7 | 1.95 | 19.87 | 79.88 | 30.95 |
| Single Layer | Thermal Evaporation | Iron (Fe) | 5 | 30 | 1.95 | 19.34 | 77.45 | 29.21 |
| Single Layer | Thermal Evaporation | Chromium (Cr) | 20 | 18 | 1.95 | 19.23 | 77.65 | 29.12 |
| Single Layer | Thermal Evaporation | Chromium (Cr) | 200 | 6 | 1.93 | 19.37 | 78.65 | 29.40 |
| Single Layer | Thermal Evaporation | Chromium (Cr) | 5 | 32 | 1.94 | 19.72 | 77.23 | 29.55 |
| Single Layer | Thermal Evaporation | Molybdenum (Mo) | 20 | 20 | 1.94 | 19.38 | 77.87 | 29.28 |
| Single Layer | Thermal Evaporation | Molybdenum (Mo) | 200 | 7 | 1.94 | 19.45 | 78.45 | 29.60 |
| Single Layer | Thermal Evaporation | Molybdenum (Mo) | 5 | 33 | 1.92 | 19.75 | 76.96 | 29.18 |
| Multi-Layer | Electron Beam Deposition | Gold (Au) Silver (Ag) | 10 10 | 5 | 1.94 | 19.46 | 80.74 | 30.48 |

| Multi-Layer | Electron Beam Deposition | Gold (Au) | 100 | 2 | 1.95 | 19.75 | 82.33 | 31.71 |
|---|---|---|---|---|---|---|---|---|
| | | Silver (Ag) | 100 | | | | | |
| Multi-Layer | Electron Beam Deposition | Gold (Au) | 3 | 8 | 1.94 | 19.64 | 78.76 | 30.01 |
| | | Silver (Ag) | 3 | | | | | |
| Multi-Layer | Electron Beam Deposition | Aluminum (Al) | 10 | 9 | 1.93 | 19.76 | 79.98 | 30.50 |
| | | Iron (Fe) | 10 | | | | | |
| Multi-Layer | Electron Beam Deposition | Aluminum (Al) | 100 | 6 | 1.96 | 19.76 | 80.32 | 31.11 |
| | | Iron (Fe) | 100 | | | | | |
| Multi-Layer | Electron Beam Deposition | Aluminum (Al) | 3 | 13 | 1.94 | 19.53 | 78.12 | 29.60 |
| | | Iron (Fe) | 3 | | | | | |
| Alloy | Electron Beam Deposition | Copper-Silver Alloy (Cu 80% / Ag 20%) | 20 | 6 | 1.94 | 19.64 | 80.15 | 30.54 |
| Alloy | Electron Beam Deposition | Copper-Silver Alloy (Cu 80% / Ag 20%) | 200 | 4 | 1.96 | 19.89 | 81.67 | 31.84 |
| Alloy | Electron Beam Deposition | Copper-Silver Alloy (Cu 80% / Ag 20%) | 10 | 10 | 1.94 | 19.77 | 78.98 | 30.29 |
| / | / | / | / | 60 | 1.91 | 19.65 | 67.65 | 25.39 |

As shown in Table 1, the tandem solar cell in the comparative example does not comprise the first deposited metal layer 120, and thus exhibits a maximum contact resistivity ($60\Omega \cdot cm$) between the metal electrode and the cell. Specifically, during the low-temperature sintering of the metal paste in the metal electrode, incomplete sintering of resins and other organic substances results in poor contact between the metal electrode and the cell.

Further, since the printing paste of the metal electrode contains a small amount of non-conductive organic substances, direct printing of the metal electrode will result in a high contact resistance between the electrode and the cell. In contrast, after the deposition of the metal layer, the contact resistance between the deposited metal layer and the cell is reduced. There is no contact resistance generated between numerous metal particles in the electrode printing paste and the deposited metal layer, so the overall contact resistance is decreased. This directly leads to a sharp increase in the fill factor of the cell performance, thereby achieving a significant improvement in the conversion efficiency of the device.

In summary, the tandem solar cell provided by the present invention can be applied in the process of preparing the electrodes of the tandem solar cell at low temperature to improve the adhesion between the metal electrode and the cell, thereby enhancing the electrical conductivity of the metal electrode, so as to increase the fill factor of the tandem solar cell.

Although the method is illustrated and described as a series of actions for the purpose of simplifying the explanation, it should be understood and appreciated that these methods are not limited by the order of the actions. Those skilled in the art may understand that some actions may occur in different orders and/or concurrently with other actions that are illustrated and described herein or that are not illustrated and described herein, in accordance with one or more embodiments.

The previous description of the disclosure is provided to enable any person skilled in the art to make or use the disclosure. Various modifications to the present disclosure will be obvious to those skilled in the art, and the general principles defined herein may be applied to other variations without departing from the spirit or scope of the disclosure. Thus, the present disclosure is not intended to be limited to the examples and designs described herein, but is to be accorded the broadest scope of the principles and novel features disclosed herein.

## Claims

1. A tandem solar cell, wherein the tandem solar cell comprises a front electrode, a first stacked layer, a tunneling recombination layer, a second stacked layer, and a back electrode, and a first deposited metal layer is provided between the front electrode and the first stacked layer.

2. The tandem solar cell according to claim 1, wherein the first deposited metal layer comprises a metal material, and the metal material comprises:

any one selected from silver, gold, copper, aluminum, iron, chromium and molybdenum, or
an alloy of two or more metals selected from silver, gold, copper, aluminum, iron, chromium and molybdenum.

3.  The tandem solar cell according to claim 2, wherein the first deposited metal layer comprises a metal material in a mass ratio of 85% to 95%.

4.  The tandem solar cell according to claim 2, wherein the first deposited metal layer has a thickness ranging from 5nm to 2000nm.

5.  The tandem solar cell according to claim 4, wherein the first deposited metal layer comprises silver, and a thickness of the first deposited metal layer ranges from 20nm to 2000nm; or
the first deposited metal layer comprises a metal material selected from gold, copper, aluminum, iron, chromium, molybdenum, or silver-copper alloy, and a thickness of the first deposited metal layer ranges from 20nm to 200nm, respectively.

6.  The tandem solar cell according to claim 2, wherein the first deposited metal layer is a multi-layer structure, and the multi-layer structure is formed by depositing a plurality of layers of the metal materials.

7.  The tandem solar cell according to claim 6, wherein the first deposited metal layer comprises a gold-silver bilayer structure or an aluminum-iron bilayer structure.

8.  The tandem solar cell according to claim 7, wherein the gold-silver bilayer structure or the aluminum-iron bilayer structure has a thickness ranging from 20nm to 200nm.

9.  The tandem solar cell according to claim 8, wherein a gold deposited metal layer and a silver deposited metal layer of the gold-silver bilayer structure have a same thickness, or
an aluminum deposited metal layer and an iron deposited metal layer of the aluminum-iron bilayer structure have a same thickness.

10. The tandem solar cell according to any one of claims 1 to 9, wherein a deposition process of the first deposited metal layer comprises at least one selected from thermal evaporation deposition, ion beam deposition, reactive plasma deposition, electron beam deposition and sputtering deposition, and the first deposited metal layer is deposited between the front electrode and the first stacked layer via the deposition process.

11. The tandem solar cell according to claim 1, wherein the first deposited metal layer is formed via electron beam deposition, and:

    the first deposited metal layer is made of silver with a thickness ranging from 20nm to 2000nm;
    the first deposited metal layer has a gold-silver bilayer structure with a thickness ranging from 20nm to 200nm; or
    the first deposited metal layer is made of a silver-copper alloy with a thickness ranging from 20nm to 200nm.

12. The tandem solar cell according to claim 1, wherein the first deposited metal layer has a pattern consistent with that of metal grid lines between the first deposited metal layer and the first stacked layer.

13. The tandem solar cell according to claim 1, further comprising a second deposited metal layer, provided between the back electrode and the second stacked layer.

14. The tandem solar cell according to claim 1, wherein the first stacked layer comprises a hole transport layer, a first absorber layer, an electron transport layer and a first transparent conductive layer, the tunneling recombination layer is a transparent conductive oxide layer, and the second stacked layer comprises a second transparent conductive layer and a second absorber layer.

15. A method for preparing the tandem solar cell according to any one of claims 1 to 14, comprising the following steps:

    preparing a second stacked layer of the tandem solar cell, wherein the second stacked layer comprises a first surface and a second surface opposite to each other, the second surface is a light-receiving surface;
    forming a tunneling recombination layer on the second surface of the second stacked layer;
    forming a first stacked layer on a surface of the tunneling recombination layer remote from the second stacked layer;

forming a first deposited metal layer on a surface of the first stacked layer remote from the tunneling recombination layer; and

forming a front electrode on a surface of the first deposited metal layer remote from the first stacked layer, and forming a back electrode on a surface of the second stacked layer remote from the tunneling recombination layer.

120

| 114 |
|---|
| 113 |
| 112 |
| 111 |
| 110 |

| 1134 |
|---|
| 1133 |
| 1132 |
| 1131 |

| 1112 |
|---|
| 1111 |

121

# FIG.1

Start

Preparing a second stacked layer of the tandem solar cell, wherein the second stacked layer comprises a first surface and a second surface opposite to each other, the second surface is a light-receiving surface

Forming a tunneling recombination layer on the second surface of the second stacked layer

Forming a first stacked layer on a surface of the tunneling recombination layer remote from the second stacked layer

Forming a first deposited metal layer on a surface of the first stacked layer remote from the tunneling recombination layer

Forming a front electrode on a surface of the first deposited metal layer remote from the first stacked layer, and forming a back electrode on a surface of the second stacked layer remote from the tunneling recombination layer

End

FIG.2

FIG.3

## INTERNATIONAL SEARCH REPORT

International application No.

**PCT/CN2025/106976**

### A. CLASSIFICATION OF SUBJECT MATTER

H10K30/50(2023.01)i

According to International Patent Classification (IPC) or to both national classification and IPC

### B. FIELDS SEARCHED

Minimum documentation searched (classification system followed by classification symbols)

IPC: H10K30, H01L

Documentation searched other than minimum documentation to the extent that such documents are included in the fields searched

Electronic data base consulted during the international search (name of data base and, where practicable, search terms used)

CNABS; CNTXT; CNKI; VEN; ENTXT; IEEE: 叠层, 多层, 附着力, 附着性, 光伏电池, 结合力, 金属, 树脂, 双层, 太阳电池, 太阳能电池, 透明导电, 透明电极, 有机, 粘附力, 粘附性, 种子层, 黏附力, 黏附性, conductive, electrode, ITO, metal, photovoltaic, solar, TCO, transparent, adhe+, line?

### C. DOCUMENTS CONSIDERED TO BE RELEVANT

| Category* | Citation of document, with indication, where appropriate, of the relevant passages | Relevant to claim No. |
|---|---|---|
| PX | CN 119546036 A (TRINA SOLAR CO., LTD.) 28 February 2025 (2025-02-28) claims 1-15, description, paragraphs [0005]-[0089], and figures 1-3 | 1-15 |
| X | JP 2013098241 A (KANEKA CORP.) 20 May 2013 (2013-05-20) description, paragraphs [0013]-[0092], and figures 1-4 | 1-2, 4-15 |
| Y | JP 2013098241 A (KANEKA CORP.) 20 May 2013 (2013-05-20) description, paragraphs [0013]-[0092], and figures 1-4 | 3 |
| Y | CN 221239629 U (ZHEJIANG WINHITECH NEW ENERGY CO., LTD.) 28 June 2024 (2024-06-28) description, paragraphs [0020]-[0027], and figures 1-3 | 3 |
| X | CN 110114889 A (JUNTAI INNOVATION (BEIJING) TECHNOLOGY CO., LTD.) 09 August 2019 (2019-08-09) description, paragraphs [0043]-[0084], and figures 1-3 | 1-2, 4-5, 10, 12-15 |
| X | CN 101694852 A (ENN SOLAR ENERGY CO., LTD.) 14 April 2010 (2010-04-14) description, paragraphs [0024]-[0037], and figures 1-4 | 1-2, 4-5, 10, 12-15 |

| ✓ | Further documents are listed in the continuation of Box C. | ✓ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **16 September 2025** | **10 October 2025** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2025/106976** |

**C.    DOCUMENTS CONSIDERED TO BE RELEVANT**

| Category* | Citation of document, with indication, where appropriate, of the relevant passages | Relevant to claim No. |
| --- | --- | --- |
| A | WO 2024082635 A1 (TONGWEI SOLAR (ANHUI) CO., LTD.) 25 April 2024 (2024-04-25) entire document | 1-15 |

Form PCT/ISA/210 (second sheet) (July 2022)

**INTERNATIONAL SEARCH REPORT**
Information on patent family members

International application No.

**PCT/CN2025/106976**

| Patent document cited in search report | | | Publication date (day/month/year) | Patent family member(s) | | | Publication date (day/month/year) |
|---|---|---|---|---|---|---|---|
| CN | 119546036 | A | 28 February 2025 | None | | | |
| JP | 2013098241 | A | 20 May 2013 | JP | 5863391 | B2 | 16 February 2016 |
| CN | 221239629 | U | 28 June 2024 | None | | | |
| CN | 110114889 | A | 09 August 2019 | KR | 20190055711 | A | 23 May 2019 |
| | | | | WO | 2019095695 | A1 | 23 May 2019 |
| | | | | JP | 2019091878 | A | 13 June 2019 |
| | | | | US | 2019148582 | A1 | 16 May 2019 |
| | | | | EP | 3486952 | A1 | 22 May 2019 |
| | | | | CN | 110114889 | B | 15 November 2022 |
| CN | 101694852 | A | 14 April 2010 | CN | 101694852 | B | 27 April 2011 |
| WO | 2024082635 | A1 | 25 April 2024 | CN | 115588718 | A | 10 January 2023 |
| | | | | CN | 115588718 | B | 14 May 2024 |

Form PCT/ISA/210 (patent family annex) (July 2022)